# EUROPÄISCHE PATENTSCHRIFT

(11) **EP 1 842 410 B1**
(45) Veröffentlichungstag und Bekanntmachung des Hinweises auf die Patenterteilung: **17.09.2008**
(21) Anmeldenummer: 05804605.3
(22) Anmeldetag: 22.11.2005
(51) Int. Cl.: H05K 9/00, H05K 5/00

(54) **ANORDNUNG F]R DIE SCHIRMUNG VON SOCKEL-PLATINEN MIT EINEM SCHIRMBLECH**
ARRANGEMENT FOR SHIELDING MOTHERBOARDS WITH A SHIELDING METAL SHEET
SYSTEME POUR BLINDER DES PLATINES DE CULOT AVEC UNE TOLE DE PROTECTION

(30) Priorität: 28.01.2005 DE 102005004158
(43) Veröffentlichungstag der Anmeldung: 10.10.2007
(73) Patentinhaber: Continental Automotive GmbH, 30165 Hannover (DE)
(72) Erfinder: BOBROWSKI, Werner, 93128 Regenstauf (DE); PETER, Claus, 93049 Regensburg (DE); SCHLEGEL, Dietmar, 93057 Regensburg (DE); SCHNEEBERGER, Johann, 92431 Neunburg v. W. (DE)
(86) Internationale Anmeldenummer: PCT/EP2005/056128
(87) Internationale Veröffentlichungsnummer: WO 2006/079430

(56) Entgegenhaltungen:
- EP-A- 0 437 313
- EP-A- 0 796 038
- US-A- 6 079 099
- US-A1- 2003 098 472
- US-A1- 2004 156 178
- US-B1- 6 687 135

## Beschreibung

Die Erfindung betrifft eine Anordnung für die Schirmung einer Sockel-Platine mittels eines Schirmblechs.

Bislang werden mit Komponenten bestückte Sockel-Platinen beim Endgerätehersteller auf eine Hauptplatine montiert. Dabei wird in einem ersten Montageschritt die Sockel-Platine über unterseitige Kontaktstellen entsprechend der Schaltungen auf dieser Sockel-Platine an die Kontaktstellen der Hauptplatine gelötet. In einem zweiten Montageschritt wird ein Schirmblech mit den entsprechenden Kontaktstellen der Hauptplatine verlötet, wobei das Schirmblech die vollständige Sockel-Platine überragt.

Hierbei ist nachteilig, dass die Lieferung von Sockel-Platinen zur Endmontage ohne eine vorherige Montage eines Schirmbleches, das einen Schutz vor elektrischen und mechanischen Schäden darstellen würde, erfolgt. Ein weiterer Nachteil ist die Verlötung von Kontakten auf der Unterseite einer Sockel-Platine mit einer Hauptplatine und die direkte Verlötung des Schirmbleches mit der Hauptplatine.

Aus der EP 0 796 038 B1 ist ein Schirmblech bekannt, das ein Substrat mit einem Hochfrequenzmodul gegenüber elektromagnetischer Strahlung abschirmt. Das Schirmblech umfasst abwärts gerichtete Vorsprünge, die an zwei Seitenwänden gebildet sind und mit dem Substrat verlötet werden, wobei eine spätere Lösung der Verbindung von der Substratunterseite her erfolgt. Darüber hinaus erfordert eine spätere Lösung dieser Verbindungen eine Erhitzung der gesamten Hauptplatine, wodurch Schäden an Bauteilen der Sockel-Platine entstehen können. Schließlich erfordern separate Transportvorgänge von Schirmblech und der Sockel-Platine sowie zusätzliche Arbeits- und Montageschritte.

Der vorliegenden Erfindung liegt daher die Aufgabe zugrunde, eine verbesserte Anordnung zur unmittelbaren Schirmung einer Sockel-Platine durch ein Schirmblech bereitzustellen. Darüber hinaus soll durch die vorliegende Erfindung sichergestellt werden, dass die Qualität der Verbindungen überwachbar ist und diese zu einem späteren Zeitpunkt ohne größeren Aufwand wieder lösbar sind.

Diese Aufgabe wird erfindungsgemäß durch ein Schirmblech und eine Anordnung für die Schirmung einer Sockel-Platine mit den Merkmalen des Anspruchs 1 und 10 gelöst. Vorteilhafte Aus- und Weiterbildungen, welche einzeln oder in Kombination miteinander eingesetzt werden können, sind Gegenstand der abhängigen Ansprüche.

Erfindungsgemäß wird ein Schirmblech so ausgeführt, dass die Abmessungen des Schirmbleches in seinem Längen- und Breiten-maß nicht über die Abmessungen der Sockel-Platine hinausgehen. Hierdurch wird vorteilhaft erreicht, dass das Schirmblech direkt auf die Sockel-Platine montiert werden kann. Die Erfindung umfasst ferner Verbindungsbeine, die abschnittsweise wechselnd nach innen und außen gerichtet sind. Dies minimiert vorteilhaft ein Verkippen des Schirmblechs. Durch die direkte Montage des Schirmbleches auf der Sockel-Platine wird ferner erreicht, dass die Sockel-Platine mit dem schützenden Schirmblech als eine Einheit transportiert bzw. auf einer Haupt-Platine montiert werden kann.

In einer Ausgestaltung der Erfindung wird bevorzugt das Schirmblech durch Steckverbindungen auf der Sockel-Platine befestigt.

In einer weiteren bevorzugten Ausgestaltung der Erfindung weist das Schirmblech wenigstens zwei Verbindungsbeine auf, die in der Höhe über den Rand des Schirmbleches herausragen. Dadurch wird vorteilhaft erreicht, dass das Schirmblech auf den Verbindungsbeinen steht und die Schirmblechkanten leicht in die Höhe gehoben sind. Elektrische Leitungen der Sockel-Platine, sowie die Lötstellen am Rand der Sockel-Platine und deren Anschlussstellen, um Kontaktstellen mit der Hauptplatine auszubilden, unterliegen damit nicht der Gefahr, kurzgeschlossen zu werden.

In einer weiteren bevorzugten Ausgestaltung der Erfindung sind die Verbindungsbeine gegenüberliegend angeordnet. Hierdurch wird eine Vereinfachung des Herstellungsprozesses und damit eine Kosteneinsparung erreicht.

Insbesondere hat sich für eine sichere Abstützung des Schirmbleches bewährt, auf der Sockel-Platine wenigstens drei Verbindungsbeine vorzusehen.

Zweckmäßigerweise lassen sich die Verbindungsbeine mit einer Klebeverbindung an der Sockel-Platine befestigen.

Alternativ oder kumulativ hierzu werden die Verbindungsbeine mit einer Lötverbindung an der Sockel-Platine befestigt. Durch die Lötverbindungen, mit der die Masse und die Signalleitungen angeschlossen werden, wird eine belastbare und wieder lösbare Verbindung erreicht.

In einer weiteren bevorzugten Ausgestaltung der Erfindung sind wenigstens abschnittsweise, beispielsweise an den vier Ecken an den Schirmblech-Rändern, Abstützflächen ausgebildet. Die Abstützflächen sind gegenüber den Verbindungsbeinen in der Höhe leicht verkürzt ausgeführt, so dass die Abstützflächen beim Aufliegen der Verbindungsbeine auf der Sockel-Platine keinen direkten Kontakt mit der Sockel-Platine haben. Dadurch wird vorteilhaft eine zuverlässige Lötung der Verbindungsbeine gewährleistet. Darüber hinaus wird eine zusätzliche mechanische Stabilität des Schirmbleches gegenüber möglichen äußeren mechanischen Einflüssen erreicht. Bei einer späteren hohen Kraftbelastung (z.B. einem Test oder dem Verbau der Module) von oben, die zu einer Deformation der Verbindungsbeine führt, dienen die Abstützflächen als zusätzliche mechanische Stütze, die einen Kurzschluss mit elektrischen Leitungen oder Lötstellen und deren Anschlussstellen mit den Schirmblechkanten verhindern.

Schließlich ist vorgeschlagen, am Rand der Sockel-Platine Ausnehmungen auszubilden. Die Ausnehmungen werden für Randkontaktierungen der Sockel-Platine mit der Hauptplatine eingesetzt. Diese Randkontaktierungen werden seitens der Sockel-Platine direkt über Leitungen angesteuert, die dann den Kontakt zur Hauptplatine herstellen. Die Geometrie des Schirmbleches ermöglicht vorteilhaft den Anschluss von Leitungen seitens der Hauptplatine an die Randkontaktierungen der Sockel-Platine auch nach der Montage des Schirmbleches auf die Sockel-Platine.

Die vorliegende Erfindung eignet sich insbesondere für komponentenbehaftete dezentrale Vor- und Endfertigungsprozesse abgeschirmter elektronischer Gesamtsysteme, insbesondere für Anwendungen in Kraftfahrzeugen.

Weitere Einzelheiten und Vorteile der Erfindung werden anhand eines Ausführungsbeispiels unter Bezugnahme auf die beigefügten Abbildungen erläutert.

Darin zeigen schematisch:
- Fig. 1: eine Seitenansicht eines Schirmblechs, das auf eine Sockel-Platine montiert wird; und
- Fig. 2: eine Seitenansicht einer Sockel-Platine, das auf eine Hauptplatine gelötet ist und ein Schirmblech das auf die Sockel-Platine montiert ist.

Bei der nachfolgenden Beschreibung einer bevorzugten Ausführungsform der vorliegenden Erfindung bezeichnen gleiche Bezugszeichen gleiche oder vergleichbare Komponenten.

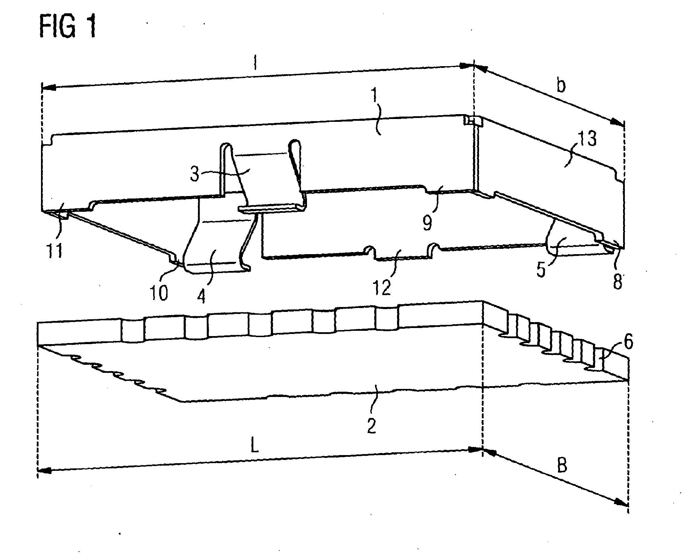

Fig. 1 zeigt in einer Seitenansicht ein Schirmblech 1, das auf eine Sockel-Platine 2 montiert wird. Das Schirmblech 1 umfasst drei Verbindungsbeine 3, 4 und 5, die den Rand 13 des Schirmbleches 1 in der Höhe in einer Größenordnung von zehntel Millimetern bis wenigen Millimetern überragen. Dadurch liegen bei einer Montage auf einer darunter liegenden Sockel-Platine 2 die Standbeine 3, 4 und 5 des Schirmbleches 1 auf der Oberfläche der Sockel-Platine 2 dergestalt auf, dass der Rand 13 des Schirmbleches 1 freistehend über der Sockel-Platine 2 angeordnet ist. Die Abstützflächen 8, 9, 10, 11 und 12 sind gegenüber den Verbindungsbeinen leicht angehoben über der Sockel-Platine angeordnet. Die Aussparungen 6 am Seitenrand der Sockel-Platine 2 ermöglichen eine Randkontaktierung mit einer Hauptplatine 7. Die Länge und Breite des Schirmbleches 1 bzw. der Sockel-Platine 2 sind mit 1 und b bzw. korrespondierend mit L und B gekennzeichnet.

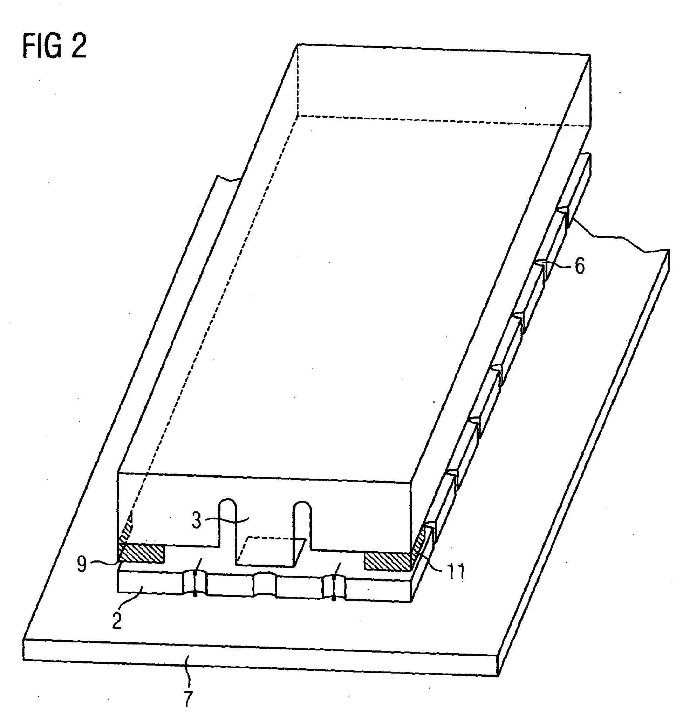

Fig. 2 zeigt in einer Seitenansicht die Sockel-Platine 2 aus Fig. 1, welche nunmehr auf einer Hauptplatine 7 gelötet ist. Das Schirmblech 1 ist entsprechend der Beschreibung von Fig. 1 auf die Sockel-Platine 2 montiert, wobei jeweils beispielhaft ein Verbindungsbein 3 und zwei Abstützflächen 9 und 11 dargestellt sind. Die Sockel-Platine 2 ist über die Aussparungen 6 für Randkontaktierungen mit der Hauptplatine 7 elektronisch verbunden. Dadurch dass die Aussparungen 6 für die Randkontaktierungen nach außen hin sichtbar sind, ist es ohne weiteres möglich, diese später zu lösen. Ebenfalls ist die Konfiguration von Schirmblech 1 und Sockel-Platine 2 mit der möglichen Befestigung über Verbindungsbeine 3, 4 und 5 sowie mit den Abstützflächen 8, 9, 10, 11 und 12 zur Stabilisierung des Schirmbleches 1 gezeigt. Hierbei sind die Abstützflächen 8, 9, 10, 11 und 12 gegenüber den Verbindungsbeinen 3, 4 und 5 in der Höhe leicht verkürzt ausgeführt, so dass die Abstützflächen 8, 9, 10, 11 und 12 im montierten Zustand des Schirmbleches 1 auf der Sockel-Platine 2 keinen direkten Kontakt zur Sockel-Platine 2 aufweisen. Diese Anordnung ist nicht nur ohne größeren Aufwand lösbar sondern erlaubt aufgrund ihrer verbesserten Zugänglichkeit direkte Qualitätstests sowohl an vormontierten wie auch auf Hauptplatinen 7 endmontierter Anordnungen.

Erfindungsgemäß bevorzugt ist das Schirmblech 1 mit drei Verbindungsbeinen 3, 4 und 5 und fünf Abstützflächen 8, 9, 10, 11 und 12 ausgebildet wobei die Verbindungsbeine entsprechend auf die Sockel-Platine 2 gelötet sind.

Darüber hinaus kann die Kontaktleitung, die zur Randkontaktierung der Aussparung 6 unter dem Verbindungsbein 3 geführt wird, in einer in Bezug auf die Sockel-Platine 2 räumlich darunter liegenden Leitungsebene geführt werden (nicht dargestellt). Dadurch wird gewährleistet, dass es keine Überkreuzung des Verbindungsbeines 3 mit einer Leitung der Sockel-Platine gibt, die zu einem Kurzschluss führen könnte.

Die vorliegende Erfindung eignet sich insbesondere für komponentenbehaftete dezentrale Vor- und Endfertigungsprozesse abgeschirmter elektronischer Gesamtsysteme, insbesondere für Anwendungen in Kraftfahrzeugen.

## Patentansprüche

1. Schirmblech (1) zur Schirmung einer Sockel-Platine (2), wobei das Schirmblech (1) in seinem Längen- (1) und Breiten-Maß (b) nicht über die Abmaße (L, B) der Sockel-Platine (2) hinausragt, **dadurch gekennzeichnet, dass** die Verbindungsbeine (3, 4, 5) am Schirmblech (1) abschnittsweise wechselnd nach innen und außen gerichtet sind.

2. Schirmblech (1) nach Anspruch 1, **dadurch gekennzeichnet, dass** die Sockel-Platine (2) Steckverbindungen zur Halterung des Schirmblechs (1) aufweist.

3. Schirmblech (1) nach Anspruch 1 oder 2, **dadurch gekennzeichnet, dass** wenigstens zwei Verbindungsbeine (3, 4, 5) über den Schirmblechrand (13) des Schirmblechs (1) herausragen.

4. Schirmblech (1) nach Anspruch 3, **dadurch gekennzeichnet das** die Verbindungsbeine (3, 4) gegenüberliegend angeordnet sind.

5. Schirmblech (1) nach einem der vorherigen Ansprüche, **dadurch gekennzeichnet, dass** wenigstens drei Verbindungsbeine (3, 4, 5) vorgesehen sind.

6. Schirmblech (1) nach einem der vorherigen Ansprüche, **dadurch gekennzeichnet, dass** die Verbindungsbeine (3, 4, 5) mittels einer Klebeverbindung mit der Sockel-Platine (1) verbunden sind.

7. Schirmblech (1) nach einem der vorherigen Ansprüche, **dadurch gekennzeichnet, dass** die Verbindungsbeine (3, 4, 5) mittels eines Lötprozesses mit der Sockel-Platine (1) verbunden sind.

8. Schirmblech (1) nach einem der vorherigen Ansprüche, **dadurch gekennzeichnet, dass** wenigstens abschnittsweise an den Schirmblech-Rändern (13) Abstützflächen (8, 9, 10, 11) ausgebildet sind.

9. Schirmblech (1) nach einem der vorherigen Ansprüche, **dadurch gekennzeichnet, dass** am Rand der Sockel-Platine (1) Ausnehmungen (6) ausgebildet sind.

10. Anordnung für die Schirmung einer Sockel-Platine (2) mittels eines Schirmblechs (1), umfassend ein Schirmblech (1) und eine Sockel-Platine (2), wobei das Schirmblech (1) in seinem Längen- (1) und Breiten-Maß (b) nicht über die Abmaße (L, B) der Sockel-Platine (2) hinausragt, **dadurch gekennzeichnet, dass** die Verbindungsbeine (3, 4, 5) am Schirmblech (1) abschnittsweise wechselnd nach innen und außen gerichtet sind.

## Claims

1. Shielding metal plate (1) for shielding a motherboard (2), wherein the length (1) and width (b) dimensions of the shielding metal plate (1) do not exceed the dimensions (L, B) of the motherboard (2), **characterised in that** the connecting legs (3, 4, 5) on the shielding metal plate (1) are orientated alternately inwards and outwards in sections.

2. Shielding metal plate (1) according to claim 1, **characterised in that** the motherboard (2) has plug-and-socket connections for the purpose of retaining the shielding metal plate (1).

3. Shielding metal plate (1) according to claim 1 or 2, **characterised in that** at least two connecting legs (3, 4, 5) project beyond the side wall (13) of the shielding metal plate (1).

4. Shielding metal plate (1) according to claim 3, **characterised in that** the connecting legs (3, 4) are disposed opposite one another.

5. Shielding metal plate (1) according to one of the preceding claims, **characterised in that** at least three connecting legs (3, 4, 5) are provided.

6. Shielding metal plate (1) according to one of the preceding claims, **characterised in that** the connecting legs (3, 4, 5) are connected to the motherboard (1) by means of an adhesive bond.

7. Shielding metal plate (1) according to one of the preceding claims, **characterised in that** the connecting legs (3, 4, 5) are connected to the motherboard (1) by means of a solder process.

8. Shielding metal plate (1) according to one of the preceding claims, **characterised in that** support surfaces (8, 9, 10, 11) are embodied at least in sections on the side walls (13) of the shielding metal plate.

9. Shielding metal plate (1) according to one of the preceding claims, **characterised in that** notches (6) are embodied at the edge of the motherboard (1).

10. Arrangement for shielding a motherboard (2) by means of a shielding metal plate (1), comprising a shielding metal plate (1) and a motherboard (2), wherein the length (1) and width (b) dimensions of the shielding metal plate (1) do not exceed the dimensions (L, B) of the motherboard (2), **characterised in that** the connecting legs (3, 4, 5) on the shielding metal plate (1) are orientated alternately inwards and outwards in sections.

## Revendications

1. Tôle de protection (1) pour la protection d'une platine de socle (2), dans laquelle la tôle de protection (1) ne déborde pas dans ses dimensions en longueur (1) ni en largeur (b) au-delà des cotes (L, B) de la platine de socle (2), **caractérisée en ce que** les pattes d'assemblage (3, 4, 5) prévues sur la tôle de protection (1) sont orientées par endroits en alternance vers l'intérieur et vers l'extérieur.

2. Tôle de protection selon la revendication 1, **caractérisée en ce que** la platine de socle (2) présente des liaisons à emmanchement destinées à retenir la tôle de protection (1).

3. Tôle de protection (1) selon la revendication 1 ou 2, **caractérisée en ce qu'**au moins deux pattes d'assemblage (3, 4, 5) débordent au-delà du bord (13) de la tôle de protection (1).

4. Tôle de protection (1) selon la revendication 3, **caractérisée en ce que** les pattes d'assemblage (3, 4) sont disposées face à face.

5. Tôle de protection (1) selon une des revendication précédentes, **caractérisée en ce qu'**il est prévu au moins trois pattes d'assemblage (3, 4, 5).

6. Tôle de protection (1) selon une des revendication précédentes, **caractérisée en ce que** les pattes d'assemblage (3, 4, 5) sont assemblées à la platine de socle (1) par un assemblage collé.

7. Tôle de protection (1) selon une des revendication précédentes, **caractérisée en ce que** les pattes d'assemblage (3,4,5) sont assemblées à la platine de socle (1) par un une opération de soudure.

8. Tôle de protection (1) selon une des revendication précédentes, **caractérisée en ce que** des surfaces d'appui (8,9,10, 11) sont formées, au moins par endroits, aux bords (13) de la tôle de protection.

9. Tôle de protection (1) selon une des revendication précédentes, **caractérisée en ce que** des évidements (6) sont formés au bord de la platine de socle (1).

10. Dispositif destiné à protéger une platine de socle (2) au moyen d'une tôle de protection (1), comprenant une tôle de protection (1) et une platine de socle (2), dans lequel la tôle de protection (1) ne déborde pas dans ses dimensions en longueur (1) ni en largeur (b) au-delà des cotes (L, B) de la platine de socle (2), **caractérisé en ce que** les pattes d'assemblage (3, 4, 5) prévues sur la tôle de protection (1) sont orientées par endroits, en alternance, vers l'intérieur et vers l'extérieur.
